# EUROPÄISCHE PATENTSCHRIFT

(11) **EP 1 887 369 B1**
(45) Veröffentlichungstag und Bekanntmachung des Hinweises auf die Patenterteilung: **27.10.2010**
(21) Anmeldenummer: 07015158.4
(22) Anmeldetag: 02.08.2007
(51) Int. Cl.: G01R 31/34, H02H 7/08

(54) **Vorrichtung und Verfahren zur Drehstromüberwachung eines Drehstromantriebs, insbesondere in der Galvanotechnik**
Device and method for monitoring the triphase current of a triphase electric motor, particularly in plating
Dispositif et procédé destinés à la surveillance du courant triphasé d'un moteur électrique triphasé, en particulier dans le domaine de la galvanoplastie

(30) Priorität: 11.08.2006 DE 102006037926; 11.08.2006 DE 202006012437 U
(43) Veröffentlichungstag der Anmeldung: 13.02.2008
(73) Patentinhaber: Pfältzer, Jürgen, 75417 Mühlacker (DE)
(72) Erfinder: Pfältzer, Jürgen, 75417 Mühlacker (DE)
(74) Vertreter: Leitner, Waldemar

(56) Entgegenhaltungen:
- EP-A- 0 845 681
- DE-A1- 3 237 800

## Beschreibung

Die Erfindung betrifft eine Vorrichtung zur Drehstromüberwachung eines Drehstromantriebs, insbesondere in der Galvanotechnik, wobei der Drehstromantrieb mehrere Phasenleiter aufweist, über die er an eine Wechselspannung angeschlossen ist, wobei die Vorrichtung mindestens einen Sensor für jeden Phasenleiter aufweist, durch den jeweils der durch den zugeordneten Phasenleiter des Drehstromantriebs fließende Strom vermessbar ist, und wobei die die Vorrichtung eine Auswerteeinheit aufweist, welcher die Meßsignale der Sensoren zugeführt werden, sowie ein Verfahren zur Drehstromüberwachung eines Drehstromantriebs, insbesondere in der Galvanotechnik, dem über mehrere Phasenleiter eine Wechselspannung zugeführt wird, wobei durch Sensoren jeweils der durch den zugeordneten Phasenleiter des Drehstromantriebs fließende Strom vermessen wird, und einer Auswerteeinheit der Vorrichtung die Meßwerte der Sensoren zugeführt werden

Eine Vorrichtung und ein Verfahren mit den Oberbegriffen der Ansprüche 1 bzw. 9 sind aus der DE 697 214 55 T bekannt. Die Funktionsweise der darin beschriebenen Vorrichtung sowie des ebenfalls offenbarten Verfahrens beruhen auf der Annahme, dass der Strom, der durch jeden entsprechenden Phasenleiter unter Normalbedingungen fließt, in einem ersten Bereich Iₙₒₘ von Stromwerten liegt, und dass Ströme in verschiedenen Phasenleitern innerhalb weniger Prozente identisch sind. Bei einem Normalbetrieb des Drehstromantriebs liegen die Stromwerte der Phasenleiter in einem ersten Bereich I_{nom.} während in dem Fall, dass die dort als Beispiel eines Drehstromantriebs beschriebene Pumpe trockenläuft, der Strom unterhalb der unteren Grenze des ersten Bereichs Iₙₒₘ abfällt und im Bereich I_{dry} liegt. Wenn die Pumpe stehen bleibt, steigt der durch die Phasenleiter fließende Strom über die obere Grenze des Bereichs Iₙₒₘ und liegt in einem dritten Strom-Band Iₛₜₐₗₗ.

Um nun den Betriebszustand der Pumpe charakterisierende Signale erzeugen zu können, werden der Auswerteeinrichtung der bekannten Vorrichtung Referenzströme zugeführt, weiche die Grenzen der oben genannten Strombereiche charakterisieren. Durch einen Vergleich des durch einen Phasenleiter fließenden Stroms mit den Referenzströmen wird festgestellt, in welchem Stromband der gemessene Strom liegt und ein dem festgestellten Strom-Band entsprechendes Signal wird erzeugt.

Die DE 32 37 800 A1 beschreibt eine elektrische Schutzeinrichtung zur Überwachung von Asynchronmotoren, die es erlaubt, Stromasymmetrien zu überwachen. Dies geschieht durch einen Vergleich der Phasenströme jeweils untereinander, und zwar derart, dass zwei Stromsensoren den Motor-Ist-Strom in jeweils einer Phase überwachen und der dritte, nicht gemessene Phasenstrom aus den beiden gemessenen Phasenströmen abgeleitet wird. In einer zwei Subtrahierer-Schaltungen und einen Komparator aufweisenden Vergleichsschaltung wird ein Vergleich auf Stromasymmetrie dahingehend durchgeführt, dass die Differenz des ersten Phasenstroms und des zweiten Phasenstroms sowie die Differenz des ersten Phasenstroms und des dritten Phasenstroms gebildet werden und die jeweils größere Differenz in dem Komparator mit dem einstellbaren Schwellwert verglichen wird. Überschreitet diese Differenz, die bei Stromsymmetrie 0 ist, den einstellbaren Schwellwert, dann liefert diese Vergleichsschaltung ein entsprechendes Abschaltsignal. Da eine derartige Vergleichsschaltung für sich allein gesehen nicht in der Lage ist, ein Abschaltsignal zu liefern, wenn eine Störung In der nicht gemessenen, sondern berechneten Phase auftritt, ist ein Summenstromwandler vorgesehen, der mit einem Auswerterelais zusammenarbeitet, um etwaige Fehlerströme zu überwachen.

Drehstromantriebe werden auch in der Galvanotechnik eingesetzt. Dort werden beispielsweise in rotierenden Trommeln befindliche Werkstücke in elektrolytischen oder chemischen Bädern beschichtet. Bleiben diese Trommeln jedoch stehen, so führt dies zur Beschädigung der Werkstücke durch "Verbrennen" infolge einer zu hohen Strombelastung bzw. in chemischen Bädern durch Zerfressen sowie allgemein durch ungleichmäßige Beschichtung oder Behandlung, so dass die Werkstücke meist irreparabel beschädigt und nicht mehr zu verwenden sind.

Aus diesem Grunde ist eine Überwachung der Drehung der Galvanisiertrommel sinnvoll, wobei die zur Überwachung eingesetzte Vorrichtung bei Stillstand der Galvanisiertrommel eine Meldung abgibt und den Anwender in die Lage versetzt, die Werkstücke aus den Bädern zu entnehmen und vor Schaden zu bewahren. Hierzu werden bereits unterschiedliche bekannte Systeme eingesetzt:

So besteht beispielsweise die Möglichkeit, die Trommeldrehung dadurch zu überwachen, dass ein Schalter angebracht wird, der bei jeder Drehung der Trommel einen Impuls abgibt. Hierzu existieren kontaktlose Systeme, die beispielsweise über fest vergossene Magnete einen Sensor im Galvanisierbad betätigen. Dies besitzt jedoch den Nachteil, dass derartige Systeme relativ rasch durch die chemische bzw. elektrolytische Belastung im Bad zerstört werden. Des weiteren besteht keine Flexibilität bezüglich der einsetzbaren Tommelabmessungen.

Bei anderen derartigen Systemen wird ein mechanischer Schalter oder Sensor wie beispielsweise ein Nockenschalter außerhalb des Galvanisierbades angebracht. Diese Vorgehensweise besitzt jedoch den Nachteil, dass eine relativ aufwendige Verkabelung sowie mechanische Einrichtungen notwendig sind. Zudem unterliegen diese Systeme der ständigen Verschmutzung aus der Umgebung und müssen daher kontinuierlich gewartet werden. Erfolgt dies nicht, führt die Verschmutzung in der Regel zu einem Ausfall des Systems.

Des weiteren kommen Systeme zum Einsatz, bei denen ein Anzeigeinstrument wie beispielsweise eine Lampe oder eine Hupe über einen Hilfskontakt des Motorschutzschalters, der den Motor in der Regel bei thermischer Überlastung eines Bimetallschalters abschaltet, in den Trommelantrieb integriert ist. Diese Systeme funktionieren jedoch nicht, wenn gerade die Phase des Drehstroms von einem Ausfall betroffen ist, die das Anzeigesystem mit Spannung versorgt, oder wenn die Werkstücke bereits vor dem Auslösezeitpunkt des Motorschutzschalters beschädigt werden.

Es ist daher Aufgabe der vorliegenden Erfindung, eine Vorrichtung sowie ein Verfahren der eingangs genannten Art derart weiterzubilden, dass bei einem einfachen Aufbau eine zuverlässige Überwachung der Funktion des Drehstromantriebs gegeben ist.

Diese Aufgabe wird erfindungsgemäß dadurch gelöst, dass zur Überwachung der Funktion des Drehstromantriebs ein Vergleich der durch die Sensoren erfaßten Ströme miteinander erfolgt, und dass durch die Vorrichtung ein einen Störungszustand des Drehstromantriebes repräsentierendes Signal erzeugbar ist, wenn durch die Auswerteeinheit eine Asymmetrie der Meßwerte der Sensoren festgestellt ist.

Beim erfindungsgemäßen Verfahren ist vorgesehen, dass zur Überwachung der Funktion des Drehstromantriebs ein Vergleich der durch die Sensoren erfaßten Ströme miteinander durchgeführt wird, und dass bei einer Funktionsstörung des Drehstromantriebs ein diesen Störungszustand repräsentierendes Signal erzeugt wird, wenn durch die Auswerteeinrichtung eine Asymmetrie der von den Sensoren erfaßten Meßwerte festgestellt wird.

Durch die erfindungsgemäßen Maßnahmen wird in vorteilhafter Art und Weise eine Vorrichtung und ein Verfahren geschaffen, bei denen die Überwachung der Funktion des Drehstromantriebs außerhalb des Arbeitsbereichs der drehenden Teile direkt über die Phasenleiter des Drehstromantriebs erfolgen kann. Auf diese Weise sind keine mechanischen Kontakte, die ein Verschmutzungsrisiko und dadurch ein Ausfallrisiko des Systems beinhalten, oder Komponenten im galvanischen Bad selbst mehr notwendig.

Hierbei werden die Phasenleiter des Drehstromantriebs vermessen und miteinander verglichen. Ergeben sich für zwei oder mehrere Phasenleiter unterschiedliche Werte der gemessenen Stromstärken, ist also eine Asymmetrie der Stromwerte gegeben, liegt ein Defekt des Drehstromantriebs vor.

Eine vorteilhafte Weiterbildung der Erfindung sieht vor, dass die durch die Sensoren erfaßten Messwerte Effektivstromstärken der Phasenleiter sind. In der Regel sind bei symmetrischen Drehstromantrieben die Effektivstromstärken sämtlicher Phasenleiter gleich. Wird nun durch die Auswerteeinheit ein Vergleich der Effektivstromstärken durchgeführt, sind auf einem Defekt des Drehstromantriebs beruhende Abweichungen eines oder mehrerer der Ströme voneinander sofort ermittelbar und aufgrund dessen eine Fehlermeldung durch die Vorrichtung ausgebbar.

Eine weitere vorteilhafte Weiterbildung der Erfindung sieht vor, dass die durch die Sensoren erfaßten Messwerte Momentanstromstärken der Phasenleiter sind. Da bei symmetrisch aufgebauten Drehstromantrieben die Summe aller in den Leitern fließenden Momentanströme Null ergibt, lässt sich durch deren Ermittlung die ordnungsgemäße Funktion des Drehstromantriebs feststellen.

Eine weitere vorteilhafte Weiterbildung der Erfindung sieht vor, dass durch die Auswerteeinheit eine Abweichungstoleranz der Meßwerte voneinander und/oder von dem Sollwert berücksichtigbar ist. Da bei realen Drehstromantrieben die Effektivstromstärken in den einzelnen Phasenleitern niemals vollständig gleich sind bzw. ihren Sollwert niemals völlig exakt einhalten, ist durch diese Maßname bei der Messung der Effektivstromstärken der Phasenleiter ein Toleranzbereich für die Abweichung dieser Ströme voneinander bzw. vom Sollwert vorgebbar, so dass die von der Vorrichtung ausgeführte Ausgabe von einem oder mehreren Signalen zum Beispiel erst ab Überschreiten der vorgegebenen Abweichungstoleranz erfolgt. Vorzugsweise ist diese Abweichungstoleranz ebenso wie der Sollwert variabel vorgebbar. Durch einen zusätzlichen Vergleich der erfaßten Messwerte mit mindestens einem Sollwert ist es darüber hinaus in vorteilhafter Art und Weise möglich, nicht nur einen Defekt des Drehstromantriebes, sondern auch eine Überlastung desselben festzustellen, die mit einem erhöhten Stromfluß und damit einem Abweichen vom Sollwert einhergeht. Eine derartige Überlastung kann durch Überladung der Trommel oder durch andere Unregelmäßigkeiten wie beispielsweise ein schwergehendes Lager oder ähnliches hervorgerufen werden. Somit sind durch die Vorrichtung in vorteilhafter Art und Weise nicht nur bestehende Defekte, sondern auch potentielle zukünftige Ausfälle erkennbar.

Eine weitere vorteilhafte Weiterbildung der Erfindung sieht vor, dass die von der Vorrichtung ausführbare Ausgabe von einem oder mehreren Signalen in einer Anzeige von gemessenen Werten und/oder einer Anzeige der ordnungsgemäßen Funktion oder der Fehlfunktion des Drehstromantriebs und/oder einer externen Ausgabe von Signalen besteht. Durch die Anzeige der gemessenen Werte, vorzugsweise des Stromes, ist die Belastungssituation des Drehstromantriebs direkt ablesbar. Weiterhin ist vorzugsweise vorgesehen, dass - vorzugsweise über Kontrolleuchten - bei Fehlfunktion des Drehstromantriebs ein Warnsignal ausgegeben wird, woraufhin der Betreiber reagieren und den Drehstromantrieb rechtzeitig abschalten sowie gegebenenfalls einer Reparatur zuführen kann. Weiterhin ist vorzugsweise für die Vorrichtung ein Signalausgang vorgesehen, der beispielsweise ein Fehlersignal an weitere Systeme ausgeben kann.

Eine weitere vorteilhafte Weiterbildung der Erfindung sieht vor, dass die Sensoren voneinander und/oder von der Auswerteeinheit galvanisch getrennt sind. Hierbei sind die jeweiligen Stromkreise von einander entkoppelt und somit nicht elektrisch sondern beispielsweise induktiv oder kapazitiv miteinander verbunden, so dass ein direkter Stromfluß nicht möglich ist. Auf diese Weise werden einzelnen Komponenten vor Beschädigungen geschützt.

Eine weitere vorteilhafte Weiterbildung der Erfindung sieht vor, dass die Vorrichtung einen Fehlerspeicher aufweist. Auf diese Weise ist es beispielsweise auch in einer nicht vollautomatisierten Handgalvanik möglich, durch nachträgliches Auslesen des Fehlerspeichers die ordnungsgemäße Funktion des Drehstromantriebs während des eigentlichen Galvanisiervorgangs festzustellen und auf diese Weise eine Qualitätssicherung zu betreiben.

Eine weitere vorteilhafte Weiterbildung der Erfindung sieht vor, dass die Vorrichtung für unterschiedliche Spannungsversorgungen ausgelegt ist und somit bei unterschiedlichen Netzspannungen in verschiedenen Regionen weltweit einsetzbar ist.

Weitere vorteilhafte Weiterbildungen der Erfindung sind Gegenstand der Unteransprüche.

Weitere Einzelheiten und Vorteile der Erfindung sind dem Ausführungsbeispiel zu entnehmen, das im folgenden anhand der einzigen Figur beschrieben wird. Es zeigt:

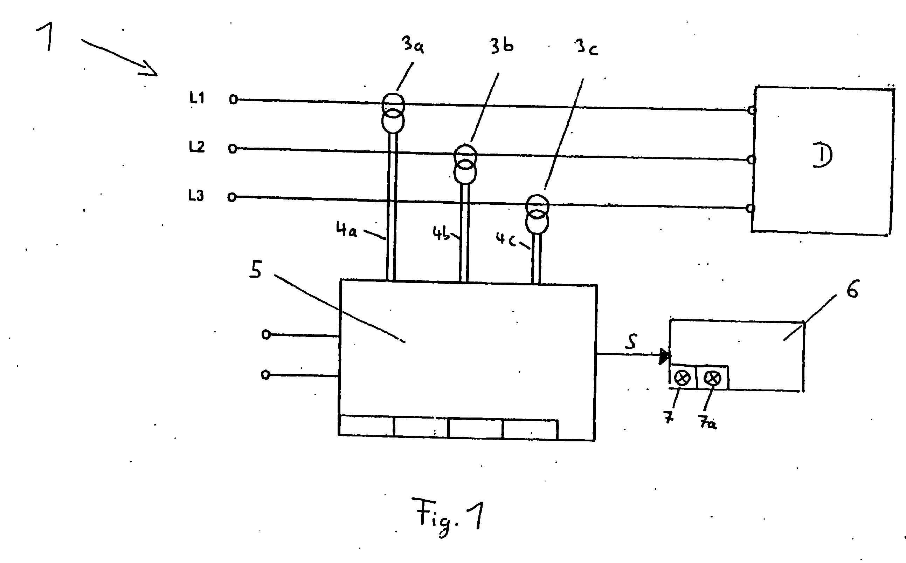

- Figur 1: eine schematische Darstellung eines Ausführungsbeispiels der vorliegenden Erfindung.

In Figur 1 ist nun ein Ausführungsbeispiel einer Vorrichtung 1 zur Drehstromüberwachung eines Drehstromantriebs D beschrieben, der über drei Phasenleiter L1 - L3 mit einer Wechselspannung versorgt wird. Ein derartiger Drehstromantrieb D wird insbesondere in der Galvanotechnik eingesetzt, um rotierende Galvanisiertrommeln anzutreiben, wie sie zum Beispiel zum Verzinken von Werkstücken verwendet werden. Die Vorrichtung 1 weist drei Sensoren 3a -3c auf, durch die jeweils der Strom, der durch den einem bestimmten Sensor 3a - 3c zugeordneten Phasenleiter L1 - L3 fließt, erfaßbar ist. Von den Sensoren 3a - 3c erzeugte Meßsignale werden über Zuleitungen 4a- 4c zu einer Auswerteeinheit 5 geleitet.

Der wesentliche Vorteil dieser Vorrichtung 1 besteht nun darin, dass zur Überwachung der Rotation der Galvanisiertrommel der Drehstrom in den drei Phasenleitern L1, L2 und L3 herangezogen wird, und nicht wie bei bisher bekannten Systemen zusätzliche mechanische Komponenten, die der Verschmutzung ausgesetzt sind, in das System eingebaut werden müssen.

Bei dem beschriebenen Ausführungsbeispiel ist vorgesehen, dass über die drei Sensoren 3a, 3b und 3c nun die Werte von Effektivstromstärken in den drei Phasenleitern L1 - L3 des dreiphasigen Wechselstroms, der den Drehstromantrieb D mit Spannung versorgt, erfaßt werden und korrespondierende Meßsignale der Auswerteeinheit 5 - vorzugsweise in Form von genormten Analogsignalen - zugeführt werden.

Die Auswerteeinheit 5 vergleicht nun die drei gemessenen Effektivstromstärken miteinander. Da bei ordnungsgemäß funktionierenden Drehstromantrieben alle drei Effektivstromstärken im wesentlichen gleich groß sind, ist eine gegebenenfalls festgestellte Abweichung in der Symmetrie der drei Effektivströme voneinander ein eindeutiges Indiz für einen Defekt oder eine Fehlfunktion des Drehstromantriebs D. Wird eine Asymmetrie der Effektivströme von der Auswerteeinheit 5 festgestellt, so wird von der Auswerteinheit 5 ein einen Störungszustand des Drehstromantriebs D repräsentierendes Signal S erzeugt. Dieses Signal S wird einer entsprechenden Anzeigeeinheit 6, zum Beispiel Kontrolleuchten 7, 7a zugeführt. Vorzugsweise weist die Anzeigeeinheit 6 hierzu eine grüne Kontrolleuchte 7, die die ordnungsgemäße Funktion anzeigt, sowie eine rote Kontrolleuchte 7a, die eine Fehlfunktion anzeigt, auf.

Da es auf diese Weise durch die beschriebene Vorrichtung 1 möglich ist, das einen Störungszustand des Drehstromantriebs D charakterisierende Signal S zu erzeugen und dadurch einen Defekt anzuzeigen, ist beispielsweise ein Bediener in diesem Fall in der Lage, die in der Galvanisiertrommel befindlichen Werkstücke rechtzeitig zu entnehmen und somit vor erheblichen Beschädigungen durch zu hohen Stromfluß, Zerfressen und/oder zu starke Beschichtung oder Behandlung zu bewahren, wodurch die Ausschussquote beim Galvanisieren erheblich gesenkt wird.

Zusätzlich verfügt die Vorrichtung 1 über die Möglichkeit, die von den Sensoren 3a, 3b und 3c gemessenen Effektivstromstärken mit einem oder mehreren Sollwerten, die vorzugsweise variabel vorgebbar sind, zu vergleichen. Hierdurch ist es nicht mehr nur möglich, die Drehstromsymmetrie, sondern zudem auch die Abweichung der Effektivströme von vorgebbaren Sollwerten durch die Auswerteeinheit 5 zu überwachen und gegebenenfalls darauf zu reagieren.

Des weiteren ist in der Auswerteeinheit 5 eine zulässige Abweichungstoleranz der Ströme voneinander und/oder von dem oder den vorgebbaren Sollwerten variabel einstellbar. Eine zulässige Abweichungstoleranz ist vorteilhaft, da bei realen Drehstromantrieben die Effektivströme der drei Phasenleiter niemals exakt gleich sind bzw. ihren Sollwert niemals völlig exakt einhalten, sondern vielmehr geringfügige Abweichungen von einander bzw. vom Sollwert aufweisen und es daher für eine reibungslose Funktion erforderlich ist, eine bestimmte Abweichungstoleranz zuzulassen.

Durch eine einstellbare Abweichungstoleranz der in den Phasenleitern L1, L2, L3 herrschenden Stromstärken von einem vorgegebenen Sollwert ist beispielsweise der Maximalstrom begrenzbar. Da die Stromstärke abhängig von der Belastung der Galvanisiertrommel ist, kann auf diese Weise Überlast vermieden werden wie sie beispielsweise durch Überladung der Galvanisiertrommel oder durch eine Schwergängigkeit der Trommel infolge eines beispielsweise vorhandenen Lagerschadens hervorgerufen werden kann. Insofern ist die Vorrichtung nicht nur zur Erkennung bereits bestehender Defekte und Fehlfunktionen, sondern auch präventiv zur Vermeidung von zukünftigen Ausfällen einsetzbar.

Bei dem beschriebenen Ausführungsbeispiel wurde davon ausgegangen, dass die Effektivstromstärken der drei Phasenleiter L1, L2 und L3 erfaßt und verglichen werden. Es ist jedoch ebenfalls möglich, die zeitabhängigen Momentanstromstärken zu erfassen und daraufhin zu vergleichen, ob ihre Summe jederzeit im wesentlichen Null ergibt, wie dies bei ordnungsgemäß arbeitenden symmetrischen Drehstromantrieben der Fall ist.

Bei der Beschreibung des Ausführungsbeispiels wurde davon ausgegangen, dass die Anzeigeeinrichtung 6 eine oder mehrere Kontrolleuchten 7, 7a aufweist. Es ist aber auch möglich, anstelle der oder zusätzlich zu den Kontrolleuchten 7, 7a die von den Sensoren 3a -3c gelieferten Messwerte oder damit korrelierte Größen anzuzeigen. Die Anzeige der erfaßten Stromwerte hat den Vorteil, dass hierdurch die Belastungssituation des Drehstromantriebs D direkt ablesbar ist. Es kann auch vorgesehen sein, dass die Vorrichtung einen Signalausgang aufweist, über den beispielsweise ein Fehlersignal an weitere Systeme ausgegeben werden kann.

Weiterhin ist für die Stromsensoren 3a, 3b und 3c untereinander als auch zur Elektronik der Auswerteeinheit 5 eine galvanische Trennung vorgesehen. Hierbei sind die Stromkreise so voneinander entkoppelt, dass Informationen nun auf nicht elektrische Weise wie beispielsweise induktiv oder kapazitiv übertragen werden. Dies dient der Sicherheit der einzelnen Komponenten, da keine elektrischen Ströme direkt fließen und diese beschädigen können.

Die Vorrichtung 1 verfügt zudem über einen Fehlerspeicher, der über eine Schnittstelle, die vorzugsweise als RS232-Schnittstelle ausgeführt ist, mittels eines herkömmlichen Rechners oder Laptops auslesbar ist. Auf diese Weise kann auch bei Betrieb einer nicht vollautomatisierten Handgalvanik ermittelt werden, ob während des eigentlichen Galvanisiervorgangs Fehlfunktionen aufgetreten sind. Die beschriebene Vorrichtung 1 dient somit als ein Mittel der Qualitätssicherung.

Selbstverständlich kann die beschriebene Vorrichtung 1 in eine bestehende automatisierte Anlagensteuerung integriert werden und somit ein bislang nur schlecht oder nicht überwachter Bereich in die Prozeßabläufe miteingebunden werden, wodurch

Verfahrenssicherheit, Prozeßtransparenz und Reproduzierbarkeit der Fertigungsabläufe erheblich zunehmen.

Hinsichtlich ihrer Spannungsversorgung ist die Vorrichtung 1 für unterschiedliche Strom- und Spannungswerte eingerichtet, so dass sie ohne zusätzlichen Aufwand bei verschiedenen herrschenden Netzspannungen in verschiedenen Regionen weltweit einsetzbar ist.

Die Vorrichtung 1 ist zudem unabhängig von Spannung und Frequenz des Drehstromantriebs, so dass auch drehzahlvariierte Drehstromantriebe überwacht werden können.

Eine Nachrüstung bestehender Drehstromantriebe mit der beschriebenen Vorrichtung ist selbstverständlich ebenfalls möglich.

## Patentansprüche

1. Vorrichtung zur Drehstromüberwachung eines Drehstromantriebs, insbesondere in der Galvanotechnik, wobei der Drehstromantrieb (D) mehrere Phasenleiter (L1, L2, L3) aufweist, über die er an eine Wechselspannung angeschlossen ist, wobei die Vorrichtung (1) mindestens einen Sensor (3a, 3b, 3c) für jeden Phasenleiter (L1, L2, L3) aufweist, durch den jeweils der durch den zugeordneten Phasenleiter (L1, L2, L3) des Drehstromantriebs (D) fließende Strom vermessbar ist, und wobei die Vorrichtung (1) eine Auswerteeinheit (5) aufweist, welcher die Meßsignale der Sensoren (3a, 3b, 3c) zugeführt werden, **dadurch gekennzeichnet, dass** zur Überwachung der Funktion des Drehstromantriebs (D) ein Vergleich der durch die Sensoren (3a, 3b, 3c) erfaßten Ströme miteinander erfolgt, und dass durch die Vorrichtung (1) ein einen Störungszustand des Drehstromantriebes (D) repräsentierendes Signal (S) erzeugbar ist, wenn durch die Auswerteeinheit (5) eine Asymmetrie der Meßwerte der Sensoren (3a, 3b, 3c) festgestellt ist.

2. Vorrichtung nach Anspruch 1, **dadurch gekennzeichnet, dass** durch die Sensoren (3a, 3b, 3c) als Messwerte Effektivatromstärken der Phasenleiter (L1, L2, L3) erfaßbar sind.

3. Vorrichtung nach Anspruch 1, **dadurch gekennzeichnet, dass** durch die Sensoren (3a, 3b, 3c) als Messwerte Momentanstromstärken der Phasenleiter (L1, L2, L3) erfaßbar sind.

4. Vorrichtung nach einem der vorangehenden Ansprüche, **dadurch gekennzeichnet, dass** durch die Auswerteeinheit (5) eine Abweichungstoleranz der Messwerte voneinander und/oder von mindestens einem Sollwert berücksichtigbar ist.

5. Vorrichtung nach Anspruch 4, **dadurch gekennzeichnet, dass** die Abweichungstoleranz und/oder mindestens einer der Sollwerte variabel vorgebbar ist.

6. Vorrichtung nach einem der vorangehenden Ansprüche, **dadurch gekennzeichnet, dass** die Vorrichtung (1) mindestens eine Anzeigeeinheit (6) aufweist, der das von der Auswerteeinheit (5) erzeugte Signal (S) zuführbar ist.

7. Vorrichtung nach einem der vorangehenden Ansprüche, **dadurch gekennzeichnet, dass** die Vorrichtung (1) mindestens eine Kontrolleuchte (7, 7a) aufweist, durch die eine ordnungsgemäße Funktion und/oder eine Fehlfunktion des Drehstromantriebs (D) anzeigbar ist.

8. Vorrichtung nach einem der vorangehenden Ansprüche, **dadurch gekennzeichnet, dass** die Stromsensoren (3a, 3b, 3c) voneinander und/oder von der Auswerteeinheit (5) galvanisch getrennt sind.

9. Verfahren zur Drehstromüberwachung eines Drehstromantriebs, insbesondere in der Galvanotechnik, dem über mehrere Phasenleiter (L1, L2, L3) eine Wechselspannung zugeführt wird, wobei durch Sensoren (3a, 3b, 3c) jeweils der durch den zugeordneten Phasenleiter (L1, L2, L3) des Drehstromantriebs (D) fließende Strom vermessen wird und einer Auswerteeinheit (5) der Vorrichtung (1) die Meßwerte der Sensoren (3a, 3b, 3c) zugeführt werden, **dadurch gekennzeichnet, dass** zur Überwachung der Funktion des Drehstromantriebs (D) ein Vergleich der durch die Sensoren (3a - 3c) erfaßten Ströme miteinander durchgeführt wird, und dass bei einer Funktionsstörung des Drehstromantriebs (D) ein diesen Störungszustand repräsentierendes Signal (S) erzeugt wird, wenn durch die Auswerteeinrichtung eine Asymmetrie der Meßwerte festgestellt wird.

10. Verfahren nach Anspruch 9, **dadurch gekennzeichnet, dass** durch die Sensoren (3a, 3b, 3c) als Messwerte Effektivstromstärken der Phasenleiter (L1, L2, L3) erfaßt werden.

11. Verfahren nach Anspruch 9, **dadurch gekennzeichnet, dass** durch die Sensoren (3a, 3b, 3c) als Messwerte Momentanstromstärken der Phasenleiter (L1, L2, L3) erfaßt werden.

## Claims

1. Device for monitoring the triphase current of a triphase electric motor, particularly in plating, wherein the triphase electric motor (D) has got several phase conductors (L1, L2, L3) by which it is connected to an alternating voltage, wherein the device (1) comprises at least one sensor (3a, 3b, 3c) for each phase conductor (L1, L2, L3) for measuring the current flowing through the phase conductor (L1, L2, L3) associated to it, and wherein the device (1) has got an evaluating unit (5), to which the measuring signals of the sensors (3a, 3b, 3c) are lead, **characterized in that** for monitoring of the function of the triphase electric motor (D) a comparison of the currents measured by the sensors (3a, 3b, 3c) with each other is performed, and that the device (1) is capable of generating a signal (S) representing a dysfunction state of the triphase electric motor (D) when the evaluating unit (5) determines an asymmetry of the measured values of the sensors (3a, 3b, 3c).

2. Device according to claim 1, **characterized in that** the sensors (3a, 3b, 3c) can gather measured as the values the root mean square currents of the phase conductors (L1, L2, L3).

3. Device according to claim 1, **characterized in that** the sensors (3a, 3b, 3c) can as gather as the measured values the instantaneous currents of the phase conductors (L1, L2, L3).

4. Device according to one of the previous claims, **characterized in that** the evaluating unit (5) can take into account a deviation tolerance of the measured values with each other and/or with at least one given value.

5. Device according to claim 4, **characterized in that** the deviance tolerance and/or at least one of the given values can be set variably.

6. Device according to one of the previous claims, **characterized in that** the device (1) has got at least one display unit (6), to which the signal (5) generated by the evaluating unit (5) can be lead.

7. Device according to one of the previous claims, **characterized in that** the device (1) has got at least one control light (7, 7a), by which a proper function and/or a dysfunction of the triphase electric motor (D) can be displayed.

8. Device according to one of the previous claims, **characterized in that** the current sensors (3a, 3b, 3c) are separated from each other and/or from the evaluating unit (5) galvanically.

9. Method for the monitoring the triphase current of a triphase electric motor, in particular in plating, to which via several phase conductors (L1, L2, L3) an alternating voltage is lead, whereby via sensors (3a, 3b, 3c) the current flowing through the associated phase conductor (L1, L2, L3) is measured and the measured values of the sensors (3a, 3b, 3c) are lead to an evaluating unit (5) of the device (1), **characterized in that** for monitoring the function of the triphase electric motor (D) a comparison of the currents measured by the sensors (3a-3c) with each other is performed, and that, in case of a dysfunction of the triphase electric motor (D), a signal (S) representing the dysfunction state is generated, when the evaluating unit (5) detects an asymmetry of the measured values.

10. Method according to claim 9, **characterized in that** via the sensors (3a, 3b, 3c) as measured values root mean square currents of the phase conductors (L1, L2, L3) are gathered.

11. Method according to claim 9, **characterized in that** by the sensors (3a, 3b, 3c) as measured values instantaneous currents of the phase conductors (L1, L2, L3) are gathered.

## Revendications

1. Dispositif destiné à la surveillance du courant triphasé d'un moteur triphasé, en particulier dans le domaine de la galvanoplastie, le moteur triphasé (D) comportant plusieurs conducteurs de phase (L1, L2, L3), par l'intermédiaire desquels il est raccordé à une tension alternative, le dispositif (1) comportant au moins un capteur (3a, 3b, 3c) pour chaque conducteur de phase (L1, L2, L3), au moyen duquel peut être mesuré respectivement le courant circulant à travers le conducteur de phase (L1, L2, L3) associé du moteur triphasé (D), et le dispositif (1) comportant une unité d'analyse (5) vers laquelle sont acheminés les signaux de mesure des capteurs (3a, 3b, 3c), **caractérisé en ce que**, pour la surveillance du fonctionnement du moteur triphasé (D), les courants mesurés par les capteurs (3a, 3b, 3c) sont comparés entre eux, et **en ce que** par le dispositif (1) peut être généré un signal (S) représentant un état de dysfonctionnement du moteur triphasé (D) lorsqu'une asymétrie des valeurs de mesure des capteurs (3a, 3b, 3c) a été constatée par l'unité d'analyse (5).

2. Dispositif selon la revendication 1, **caractérisé en ce que** des intensités de courant effectives des conducteurs de phase (L1, L2, L3) peuvent être enregistrées par les capteurs (3a, 3b, 3c) en tant que valeurs de mesure.

3. Dispositif selon la revendication 1, **caractérisé en ce que** des intensités de courant actuelles des conducteurs de phase (L1, L2, L3) peuvent être enregistrées par les capteurs (3a, 3b, 3c) en tant que valeurs de mesure.

4. Dispositif selon l'une quelconque des revendications précédentes, **caractérisé en ce qu'**une tolérance de divergence des valeurs de mesure entre elles et/ou d'au moins une valeur de consigne peut être prise en compte par l'unité d'analyse (5).

5. Dispositif selon la revendication 4, **caractérisé en ce que** la tolérance de divergence et/ou au moins une des valeurs de consigne peuvent être prédéfinies de manière variable.

6. Dispositif selon l'une quelconque des revendications précédentes, **caractérisé en ce que** le dispositif (1) comporte au moins une unité de signalisation (6), vers laquelle peut être acheminé le signal (S) généré par l'unité d'analyse (5).

7. Dispositif selon l'une quelconque des revendications précédentes, **caractérisé en ce que** le dispositif (1) comporte au moins un voyant de contrôle (7, 7a) par lequel est signalé un bon fonctionnement et/ou un dysfonctionnement du moteur triphasé (D).

8. Dispositif selon l'une quelconque des revendications précédentes, **caractérisé en ce que** les capteurs de courant (3a, 3b, 3c) sont séparés par voie galvanique les uns des autres et/ou de l'unité d'analyse (5).

9. Procédé destiné à la surveillance du courant triphasé d'un moteur triphasé, en particulier dans le domaine de la galvanoplastie, vers lequel une tension alternative est acheminée par l'intermédiaire de plusieurs conducteurs de phase (L1, L2, L3), sachant que le courant circulant à travers le conducteur de phase (L1, L2, L3) associé du moteur triphasé (D) est mesuré respectivement par des capteurs (3a, 3b, 3c) et les valeurs de mesure des capteurs (3a, 3b, 3c) sont acheminées vers une unité d'analyse (5) du dispositif (1), **caractérisé en ce que**, pour la surveillance du fonctionnement du moteur triphasé (D), les courants mesurés par les capteurs (3a, 3b, 3c) sont comparés entre eux, et **en ce que**, dans le cas d'un dysfonctionnement du moteur triphasé (D), un signal (S) représentant cet état de dysfonctionnement est généré lorsque l'unité d'analyse (5) constate une asymétrie des valeurs de mesure.

10. Procédé selon la revendication 9, **caractérisé en ce que** des intensités de courant effectives des conducteurs de phase (L1, L2, L3) sont enregistrées par les capteurs (3a, 3b, 3c) en tant que valeurs de mesure.

11. Procédé selon la revendication 9, **caractérisé en ce que** des intensités de courant actuelles des conducteurs de phase (L1, L2, L3) sont enregistrées par les capteurs (3a, 3b, 3c) en tant que valeurs de mesure.
